# DEMANDE DE BREVET EUROPEEN

(11) **EP 1 603 238 A1**
(43) Date de publication de la demande: **07.12.2005**
(21) Numéro de dépôt: 05366003.1
(22) Date de dépôt: 02.06.2005
(51) Int. Cl.: H03K 19/00, G06F 1/28

(54) **Circuit d'inhibition à hystérésis et à faible consommation**

(30) Priorité: 02.06.2004 FR 0405904
(71) Demandeur: Stimicroelectronics SA, 92120 Montrouge (FR)
(72) Inventeur: Forel, Christophe Novagraaf Technologies, 57070 Metz (FR); Cittadini, Robert Novagraaf Technologies, 57070 Metz (FR)
(74) Mandataire: Bouchet, Geneviève

(57) **Abrégé**

L'invention concerne un circuit d'inhibition pour produire un signal d'inhibition (OUT) lorsqu'une variation d'un potentiel d'alimentation (VDD) est détectée, le circuit d'inhibition comprenant un comparateur (10) comprenant une entrée négative (A1) connectée à un générateur (20) produisant un potentiel de référence (VREF), et une entrée positive connectée à une sortie d'un premier circuit image produisant un premier potentiel image (VB11) du potentiel d'alimentation (VDD).

Selon l'invention, le premier circuit image (30) comprend une diode (D2) et un circuit (50, Q9, T2, T3, T4) de production d'un courant de référence (IREF4) connecté en parallèle entre un point commun sur lequel est appliqué le potentiel d'alimentation (VDD) et une sortie du premier circuit image (30) connectée à l'entrée positive (B1) du comparateur (10).

Application aux circuits intégrés portables à très faible consommation au repos, par exemple dans le domaine de la téléphonie mobile.

## Description

L'invention concerne un circuit d'inhibition, notamment intéressant pour des circuits intégrés à faible consommation et pour lesquels une robustesse importante est exigée. L'invention trouve par exemple une application dans les applications embarquées telle que la téléphonie mobile (GSM, etc.).

Dans les applications embarquées, la consommation d'un circuit intégré est un problème crucial dans la mesure où la quantité d'énergie disponible, et donc l'autonomie du circuit intégré, est limitée. Par ailleurs, notamment pour des applications à destination du grand public, les circuits intégrés doivent être robustes et doivent pouvoir en particulier supporter des variations de tension ou de courant non souhaitées importantes. Egalement, des contraintes liées à la densité d'intégration des circuits doivent être prises en compte lors de leur réalisation.

Les circuits intégrés utilisés notamment dans les applications embarquées comprennent de manière générale un générateur d'alimentation interne, un ou plusieurs circuits fonctionnels et un circuit d'inhibition. Le générateur d'alimentation interne a pour fonction de produire un potentiel d'alimentation stable VDD à partir d'une source d'énergie qui peut être une batterie ou bien un signal énergétique radiofréquence. Initialement à 0 lors de la mise sous tension du circuit intégré, le potentiel VDD produit croît rapidement pour atteindre sa valeur nominale VDD0 stable. Les circuits fonctionnels sont par exemple des mémoires, des circuits de téléphonie mobile, etc.

Le circuit d'inhibition a quant à lui pour fonction d'empêcher le fonctionnement des circuits fonctionnels avals si le potentiel d'alimentation VDD n'a pas une valeur suffisante pour pouvoir garantir un fonctionnement correct de ces circuits fonctionnels. Ainsi, à la mise sous tension du circuit intégré, le circuit d'inhibition produit un signal inactif empêchant les circuits fonctionnels avals de démarrer tant que VDD n'a pas atteint un seuil VSM. Puis, lorsque VDD a atteint sa valeur nominale, le circuit d'inhibition détecte une éventuelle chute du potentiel VDD et produit un signal inactif si VDD descend en dessous d'un seuil VSD pour bloquer à nouveau les circuits fonctionnels avals.

De manière connue, un circuit d'inhibition comprend un comparateur comprenant une entrée négative connectée à un générateur produisant un potentiel de référence VREF, et une entrée positive sur laquelle on applique une image du potentiel d'alimentation VDD. L'image est obtenue par l'intermédiaire d'un pont diviseur résistif qui permet d'ajuster le niveau de potentiel sur l'entrée positive en fonction du niveau du potentiel VREF. Le comparateur produit un signal d'activation, pour activer ou inhiber le fonctionnement des circuits fonctionnels avals selon que le potentiel d'alimentation VDD est supérieur ou non à un seuil. Lorsqu'un seuil en montée et un seuil en descente différents sont souhaités, on utilise généralement deux ponts diviseurs résistifs, chacun fournissant une image de VDD de niveau adapté, et on applique sur l'entrée positive du comparateur l'image fournie par le premier pont diviseur ou l'image fournie par le deuxième pont diviseur selon que VDD augmente ou décroît.

Les circuits d'inhibition selon l'art antérieur présentent deux inconvénients principaux.

Un premier inconvénient est la consommation énergétique importante des ponts diviseurs de tensions. Pour réduire la consommation énergétique, il faudrait réduire le courant circulant dans de tels ponts diviseurs en augmentant la taille des résistances. Cependant, ceci est incompatible avec une densité d'intégration forte.

Un deuxième inconvénient est la sensibilité des circuits d'inhibition connus, qui ont tendance à réagir très voire trop rapidement à de brusques variations de VDD, de fortes amplitudes mais de faible durée. Ces brusques variations (en anglais "burst" ou "glitch") sont inévitables dans certaines applications portables et notamment en téléphonie ; elles sont présentes en particulier en sortie du générateur d'alimentation et sont dues par exemple à un enlèvement brusque de la source d'énergie utilisée par le générateur d'alimentation. A titre indicatif, pour un potentiel VDD de l'ordre de 3 à 3.5 V alimentant un circuit intégré dans une application GSM, on trouve fréquemment sur le potentiel VDD des variations brusques de l'ordre de 600 mV.

Tant qu'elles ne vont pas en dessous d'un certain seuil, ces brusques variations ne sont pas dommageables pour les circuits fonctionnels avals si elles ne durent pas. Par contre, chaque fois que le circuit d'inhibition désactive les circuits fonctionnels après une chute du potentiel VDD, il est nécessaire de réinitialiser le circuit d'inhibition avant qu'il ne puisse jouer à nouveau pleinement son rôle. Le plus souvent, une initialisation du circuit d'inhibition suppose également de désactiver puis de réactiver le générateur d'alimentation, avec toutes les conséquences que cela implique en terme de disponibilité du circuit et de consommation d'énergie notamment. Un circuit d'inhibition trop sensible entraîne donc une surconsommation d'énergie inutile et une moindre disponibilité des circuits fonctionnels avals.

L'invention a pour objet principal de proposer un circuit d'inhibition à très faible consommation d'énergie. L'invention a pour objectif secondaire de proposer un circuit d'inhibition peu ou moins sensible aux brusques variations du potentiel d'alimentation.

Ainsi, l'invention concerne un circuit d'inhibition pour produire un signal d'inhibition lorsqu'une variation d'un potentiel d'alimentation est détectée, le circuit d'inhibition comprenant un comparateur comprenant une entrée négative connectée à un générateur produisant un potentiel de référence, et une entrée positive connectée à une sortie d'un premier circuit image produisant un premier potentiel image du potentiel d'alimentation.

Selon l'invention, le premier circuit image comprend une diode et un circuit de production d'un courant de référence connecté en parallèle entre un point commun sur lequel est appliqué le potentiel d'alimentation et une sortie du premier circuit image connectée à l'entrée positive du comparateur.

Le premier circuit image est un circuit d'hystérésis qui, selon l'invention, ne comprend pas de résistance, de sorte qu'il consomme peu d'énergie. De par la construction du premier circuit image, le premier potentiel image est égal au potentiel d'alimentation diminué d'un seuil de potentiel caractéristique de la diode.

Le circuit d'inhibition selon l'invention est complété avantageusement par un deuxième circuit image pour produire un deuxième potentiel image proportionnel au potentiel d'alimentation et un moyen de sélection pour connecter à l'entrée positive du comparateur, en fonction d'un signal de sélection :
- soit la sortie du deuxième circuit image si le potentiel d'alimentation varie entre 0 et un seuil de montée après avoir pris une valeur inférieure à un seuil de descente
- soit la sortie du premier circuit image si le potentiel d'alimentation varie entre une valeur nominale du potentiel d'alimentation (VDD) et le seuil de descente après avoir pris une valeur supérieure au seuil de montée.

L'utilisation de deux circuits image permet d'obtenir un circuit d'inhibition ayant deux seuils de détection différents, en utilisant un comparateur simple.

Selon un autre aspect de l'invention, le circuit de production du courant de référence comprend une source pour produire un courant stable, et des moyens de recopie du dit courant stable pour produire le courant de référence.

Préférentiellement, la source comprend un ensemble de transistors bipolaires associés à une résistance R3 formant une structure de type band-gap produisant le courant de référence égal à VT/R3, VT étant un paramètre caractéristique d'un transistor bipolaire. On obtient ainsi un courant de référence indépendant de VDD et de très faible valeur, sans utiliser de résistance importante comme on le verra mieux par la suite.

De préférence encore, la source comprend également un circuit d'initialisation pour décharger un condensateur parasite d'un transistor bipolaire dans lequel circule le courant stable. Ainsi initialisée, la source de courant produit le courant stable rapidement après l'application du potentiel VDD.

Dans un mode de réalisation préféré, le circuit d'initialisation est une diode comprenant un premier pôle sur lequel est appliqué le potentiel d'alimentation et un deuxième pôle connecté à un collecteur du dit transistor dans lequel circule le courant stable.

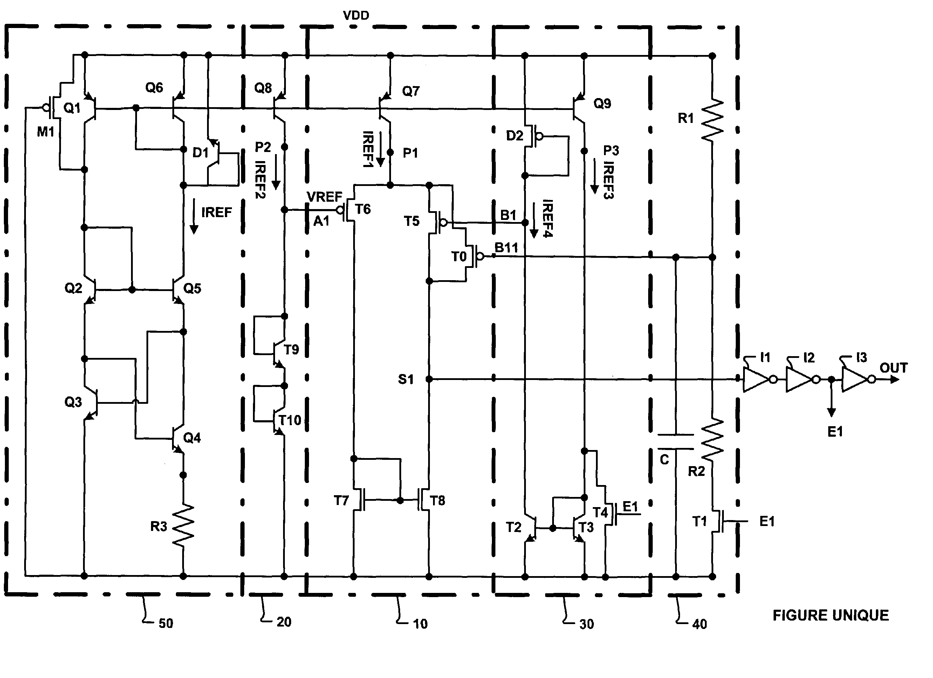

D'autres caractéristiques et avantages de l'invention ressortiront clairement de la description qui est faite ci-après d'un mode préféré de réalisation d'un circuit d'inhibition selon l'invention. Cette description est faite à titre indicatif et nullement limitatif, en référence au dessin unique annexé, dans lequel la figure 1 est un circuit électronique d'un tel circuit d'inhibition.

Le circuit de la figure 1 comprend un comparateur 10, un générateur de potentiel 20, un premier circuit image 30, et un deuxième circuit image 40. Le circuit d'inhibition surveille un potentiel VDD fourni par un générateur non représenté, et produit un signal d'inhibition OUT destiné à autoriser ou non le fonctionnement de circuits fonctionnels avals (non représentés). A la mise sous tension du circuit intégré global, le potentiel VDD est initialement nul et croît rapidement jusqu'à atteindre sa valeur nominale VDD0.

Le circuit d'inhibition comprend également un générateur de courant de référence 50, comprenant 9 transistors bipolaires Q1 à Q9, une diode D1, un transistor M1 et une résistance R3. Le générateur 50 produit trois courants de référence IREF1, IREF2, IREF3, indépendants ; le générateur 50 est fonctionnellement équivalent à trois générateurs indépendants produisant chacun un courant de référence.

Les transistors Q1 à Q6 et la résistance R3 sont connectés selon un schéma connu pour former un générateur de courant de référence stable de type VT/R. Dans une première branche, le transistor Q1, de type PNP, et les transistors Q2, Q3, de type NPN sont connectés en série, le potentiel VDD étant appliqué sur l'émetteur de Q1 et l'émetteur de Q3 étant connecté à une masse du circuit. Dans une deuxième branche, le transistor Q6, de type PNP et les transistors Q5, Q4, de type NPN, sont connectés en série, le potentiel VDD étant appliqué sur le collecteur de Q6 et le collecteur de Q4 étant connecté à un pôle de la résistance R3 dont l'autre pôle est connecté à la masse. Une base de Q1 est connectée à une base et un collecteur de Q6. Une base de Q5 est connectée à une base et à un collecteur de Q2. Une base de Q3 est connectée à un émetteur de Q5 et une base de Q4 est connectée à un émetteur de Q2.

Lorsque le potentiel VDD est appliqué sur les deux branches du générateur 50 et que le générateur a atteint un équilibre, le courant IREF circulant dans le transistor Q6 est égal à VT/R3, VT étant un paramètre intrinsèque bien connu d'un transistor bipolaire, égal à k.T/q, k étant la constante de Boltzman, T la température et q la charge élémentaire. VT est égal à 26 mV pour T = 300 K. En choisissant une résistance R3 de l'ordre de 150KΩ, on obtient ainsi un courant IREF faible de l'ordre de 0,17µA. IREF est indépendant du potentiel VDD.

Les transistors Q7, Q8, Q9 ont tous un émetteur sur lequel est appliqué le potentiel VDD et une base connectée à la base de Q6. Les transistors Q7, Q8, Q9 sont des transistors de recopie. Le transistor Q7 produit sur son collecteur P1 un courant IREF1 = a.IREF, le transistor Q8 produit sur son collecteur P2 un courant IREF2 = b.IREF et le transistor Q9 produit sur son collecteur P3 un courant IREF3 = c.IREF. IREF1, IREF2, IREF3 sont ainsi des courants de référence tout aussi stable que IREF. Les constantes a, b, c sont fonction de la taille respective des transistors Q7, Q8, Q9 par rapport à la taille du transistor Q6.

Les trois courants seront utilisés respectivement par le comparateur 10, le générateur de potentiel 20 et le premier circuit image 30, comme on va le voir par la suite.

Le générateur de courant 50 est complété selon l'invention par l'ajout d'une diode D1, connectée entre le collecteur de Q5, au potentiel VDD, et le collecteur de Q6. La diode D1 permet d'initialiser très rapidement le générateur de courant 50 lorsque le potentiel VDD lui est appliqué. En effet, le transistor Q5, parce qu'il est de type bipolaire, présente un condensateur parasite de forte capacité entre son collecteur et la masse. La diode D1 permet, quand VDD descend très vite de VDD0 à 0, de décharger ce condensateur parasite ; D1 permet ainsi à la source de courant d'être de nouveau rapidement opérationnelle quand VDD remonte.

Le générateur 50 est également complété par l'ajout d'un transistor M1 de type PMOS en parallèle sur le transistor Q1. Le drain de M1 est connecté au collecteur de Q1 et sa grille est connectée à la masse. Le potentiel VDD est appliqué sur la source de M1. La grille de M1 étant à la masse, le transistor M1 est toujours passant dès l'application du potentiel VDD, même si VDD est faible et n'a pas encore atteint sa valeur nominale. M1 permet d'injecter un petit courant dans la branche constituée des transistors Q1, Q2, Q3, de sorte à démarrer le générateur de courant dès sa mise sous tension, c'est-à-dire dès l'application du potentiel VDD.

Le comparateur 10 est réalisé selon un schéma connu, comprenant une source de courant (transistor Q7) produisant un courant IREF1 sur le pôle P1 et cinq transistors T0, T5 à T8. Le transistor T6 de type P et le transistor T7 de type N sont montés en série entre le pôle P1 et une masse du circuit. La grille de T6 forme une entrée A1 négative du comparateur 10 et la grille de T7 est connectée à son drain. Le transistor T5 de type P et le transistor T8 de type N sont montés en série entre le pôle P1 et la masse. La grille de T5 forme une entrée positive B1 du comparateur 10 et la grille de T8 est connectée à la grille de T7. Le transistor T0 de type P est quant à lui connecté en parallèle sur le transistor T5 et sa grille forme une deuxième entrée positive B11 du comparateur 10. Le drain commun S1 des transistors T5, T8 est connecté à l'entrée d'une série de trois inverseurs logiques I1, I2, la sortie du troisième inverseur I3 formant une sortie OUT du comparateur 10. Les trois inverseurs forment un étage de gain. L'inverseur I1 permet de transformer le potentiel au point S1, analogique, en un signal logique propre, égal à 0 ou VDD. La sortie de l'inverseur I2 produit un signal de sélection E1. Le signal de sélection est égal au signal au point S1. Le signal E1 est ici inversé pour obtenir le signal OUT d'activation des circuits fonctionnels avals.

Le comparateur 10 fonctionne de la manière suivante. Lorsque le potentiel sur l'entrée positive B1 ou B11 est inférieur au potentiel VREF sur l'entrée négative A1, les transistors T6, T7, T8 sont bloqués et le transistor T5 ou T0, passant, impose au point S1 un potentiel proche de VDD. Inversement, lorsque le potentiel sur l'entrée positive B1 ou B11 est supérieur au potentiel VREF sur l'entrée négative A1, le transistor T5 ou T0 est bloqué, les transistors T6, T7, T8 sont passants et le transistor T8 impose au point S1 un potentiel proche d'un seuil de diode, soit zéro.

Le générateur de potentiel de référence 20 comprend deux diodes connectées en série entre le pôle P2 d'une source de courant (transistor Q8) produisant IREF2 et la masse du circuit. Les diodes sont ici réalisées à partir de transistors bipolaires T9, T10 dont une base est connectée à un collecteur. L'association des deux diodes impose ainsi au pôle P2 un potentiel VREF égal à deux fois la tension émetteur base d'un transistor bipolaire, c'est-à-dire de l'ordre de 1,3 à 1,4 V. Le pôle P2 est connecté à l'entrée négative du comparateur 10.

Le premier circuit image 30 comprend une diode D2, deux transistors bipolaires NPN T2, T3, un transistor T4 de type NMOS et un transistor Q9 qui produit (par recopie du courant IREF) le courant de référence IREF3 sur le pôle P3. Le potentiel d'alimentation VDD est appliqué sur un premier pôle de la diode D2 dont un deuxième pôle est connecté au collecteur du transistor T2 dont l'émetteur est connecté à la masse. La base du transistor T2 est connectée à la base et au collecteur du transistor T3 dont l'émetteur est connecté à la masse. Le collecteur de T3 est par ailleurs connecté au pôle P3 et au drain du transistor T4 dont la source est connectée à la masse. Le signal de sélection E1, fourni par le comparateur 10, est appliqué sur la grille de T4. Enfin, le point commun de la diode D2 et du transistor T2 est connecté à l'entrée positive B1 du comparateur 10.

Le transistor Q9 et les transistors T2, T3, T4 forment ensemble un générateur de courant commandé par le signal E1, connecté en parallèle sur la diode D2 et qui :
- est inactif lorsque le signal E1 est actif (VDD)
- est actif et fait circuler le courant IREF4 dans la diode D2 lorsque le signal E1 est inactif (0)

Le fonctionnement global du circuit 30 est le suivant. Le transistor T4 sert à activer ou désactiver le circuit 30, en fonction du signal E1 : lorsque le signal E1 est actif (égal à VDD), T4 est passant et le courant IREF3 s'écoule vers la masse, le circuit 30 est donc inactif. Inversement, lorsque le signal E1 est inactif (égal à 0), T4 est bloqué et le courant IREF3 s'écoule vers le transistor T3. Les transistors T2, T3 forment un miroir de courant qui recopie le courant IREF3 en un courant IREF4 dans la branche constituée de la diode D2 et du transistor T2. Lorsque aucun courant ne circule dans cette branche, le potentiel B1 à l'entrée du comparateur est forcé à VDD ce qui désactive T5. Lorsque au contraire le courant circule dans cette branche (T4 bloqué), la diode D2 impose sur l'entrée positive B1 du comparateur 10 un potentiel égal à VDD - VD2, où VD2 est un seuil de tension de la diode D2, de l'ordre de 0,95 à 1 V. Le potentiel au point B1 étant inférieur à VDD, le transistor T5 de type P est passant. La diode D2 permet ainsi de garantir que le transistor T5 est toujours passant lorsqu'un courant traverse la dite diode.

Le deuxième circuit image 40 comprend quant à lui deux résistances R1, R2 et un transistor T1 NMOS associés en série, le potentiel VDD est appliqué sur un pôle de la résistance R1 et la source du transistor T1 est connectée à la masse. Le point commun des résistances R1, R2 est connecté à l'entrée positive B11 du comparateur et le signal de sélection E1 est appliqué sur la grille du transistor T1. Lorsque le signal E1 est actif (égal à VDD), T1 est passant, un courant circule dans les deux résistances R1, R2 de sorte que le point commun B11 des deux résistances est au potentiel VDD*R2/(R1+R2). Lorsque E1 est inactif (égal à 0), le transistor T1 est bloqué de sorte que le potentiel au point B11 est forcé à VDD via R1, ce qui bloque le transistor T0.

Le circuit 40 est complété par un condensateur C connecté entre le point commun des résistances R1, R2 et la masse. Le condensateur C sert de filtre passe-bas. Le potentiel au point B1 suit ainsi les fluctuations de VDD mais elles sont retardées et amorties par le condensateur C.

On notera que les transistors T1, T4, passants ou bloqués selon le signal E1, forment un moyen de sélection du premier circuit image 30 ou du deuxième circuit image 40, et de connexion de l'un ou de l'autre à l'entrée positive (plus précisément à la grille du transistor T0 ou T5) du comparateur 10. En effet, comme on vient de le voir, lorsque E1 est actif, égal à VDD, le potentiel B1 est forcé à VDD et le potentiel B11 est égal à VDD * R2/(R1+R2). Inversement, lorsque le signal E1 est inactif, égal à 0, le potentiel B11 est forcé à VDD via R1 et le potentiel B1 est égal à VDD - VD2.

On notera également que l'ensemble formé par le comparateur 10 et les circuits 30, 40 image forment un comparateur à hystérésis à deux seuils, dont le fonctionnement global est connu et décrit ci-dessous.

A la mise sous tension, VDD est faible, le potentiel au point S1 est proche de VDD et le signal E1 est égal à VDD. Le circuit 30 est inactif (potentiel B1 forcé à VDD) et le circuit 40 est actif : le potentiel B11 égal à VDD
* R2/(R1+R2). Tant que B11 est inférieur à VREF, c'est-à-dire VDD inférieur à VSM = VREF * (R1+R2)/R2, le potentiel S1 reste égal à VDD et le signal OUT est inactif : les circuits fonctionnels avals sont initialisés.

Lorsque VDD dépasse le seuil VSM, le comparateur 10 bascule, le potentiel au point S1 passe à 0 V, le signal OUT prend la valeur VDD et active les circuits fonctionnels avals. Le signal E1 est quant à lui égal à 0 et les transistors T1, T4 se bloquent. T1 étant bloqué, le circuit 40 est inactif et le potentiel B11 est forcé à VDD. T4 étant bloqué, les transistors T2, T3 sont passants de sorte que le potentiel au point B1 est égal à VDD - VD2. Tant que B1 est supérieur à VREF, c'est-à-dire tant que VDD est supérieur à VSD = VREF + VD2, alors le potentiel au point S1 reste à 0 V et le signal OUT est maintenu à VDD, actif.

En pratique, la diode D2, le générateur 20 produisant VREF et les résistances R1, R2 sont dimensionnés en fonction des valeurs souhaitées pour les seuils VSM, VSD. Dans un exemple, on choisit VSM, VSD soient de l'ordre de 1,8 à 2,0 V pour un potentiel VDD de 3 V.

Par rapport à des circuits d'inhibition connus, le circuit d'inhibition selon l'invention et tel que décrit ci-dessus consomme très peu d'énergie. En effet, le circuit 40, consommateur du fait de la présente des résistances R1, R2, est actif uniquement pendant la phase de démarrage du circuit intégré, c'est-à-dire à la mise sous tension et jusqu'à ce que le potentiel VDD ait atteint le seuil VSM. Cette phase étant très brève, la consommation d'énergie correspondante est également limitée. Le circuit 30 est quant à lui actif pendant toute la durée de fonctionnement du circuit intégré, pour détecter une éventuelle chute du potentiel VDD. Le circuit 30 par contre, réalisé uniquement à base de transistors, consomme très peu d'énergie.

La consommation du circuit d'inhibition selon l'invention est également limitée par l'utilisation d'un générateur de courant 50 fournissant un très faible courant IREF en consommant très peu d'énergie. IREF étant égal à VT/R3, il est possible d'obtenir un faible courant avec une faible résistance R3 dans la mesure où VT est faible (25 mV pour une température de 300K).

A noter encore que le comparateur 10 (et donc également le circuit d'inhibition) ne peut remplir sa fonction tant que le courant IREF n'est pas disponible et tant que VDD n'a pas atteint une valeur VMIN minimale suffisante pour rendre passante l'une des deux branches du comparateur 10. Ceci n'est pas gênant dans la mesure où :
- le courant IREF est disponible très rapidement après la mise sous tension, notamment grâce au transistor M1 et surtout grâce à la diode D1 du générateur de courant 50, dans le cas d'un d'une chute brève du potentiel d'alimentation VDD
- la valeur minimale VMIN est fixée par les seuils de tension des transistors Q7, T6, T7, sont la somme (de l'ordre de 1,5 V) est inférieure au seuil de basculement VSM.

Le circuit d'inhibition est ainsi actif bien avant que le potentiel VDD soit suffisant pour alimenter correctement les circuits fonctionnels avals.

A noter enfin, que le circuit d'inhibition est peu sensible aux brusques variations de VDD d'amplitude moyenne inférieure à 1 V mais de faible durée, du fait de la présente du condensateur C dans le circuit 40.

## Revendications

1. Circuit d'inhibition pour produire un signal d'inhibition (OUT) lorsqu'une variation d'un potentiel d'alimentation (VDD) est détectée, le circuit d'inhibition comprenant un comparateur (10) comprenant une entrée négative (A1) connectée à un générateur (20) produisant un potentiel de référence (VREF), et une entrée positive connectée à une sortie d'un premier circuit image produisant un premier potentiel image (VB1) du potentiel d'alimentation (VDD),
le circuit d'inhibition étant **caractérisé en ce que** le premier circuit image (30) comprend une diode (D2) et un circuit (50, Q9, T2, T3, T4) de production d'un courant de référence (IREF4) connecté en parallèle entre un point commun sur lequel est appliqué le potentiel d'alimentation (VDD) et une sortie du premier circuit image (30) connectée à l'entrée positive (B1) du comparateur (10).

2. Circuit selon la revendication 1, dans lequel le premier potentiel image (VB1) est égal au potentiel d'alimentation (VDD) diminué d'un seuil (VD2) de potentiel caractéristique de la diode (D2).

3. Circuit selon l'une des revendications précédentes, comprenant également un deuxième circuit image (40) pour produire un deuxième potentiel image (VB11) proportionnel au potentiel d'alimentation (VDD) et un moyen de sélection (T1, T5, T4, T0) pour connecter à l'entrée positive du comparateur, en fonction d'un signal de sélection (E1) :
• soit la sortie du deuxième circuit image (40) si le potentiel d'alimentation varie entre 0 et un seuil de montée (VM) après avoir pris une valeur inférieure à un seuil de descente (VD)
• soit la sortie du premier circuit image si le potentiel d'alimentation (VDD) varie entre une valeur nominale (VDD0) du potentiel d'alimentation (VDD) et le seuil de descente (VD) après avoir pris une valeur supérieure au seuil de montée (VM).

4. Circuit selon la revendication 3, dans lequel le moyen de connexion comprend :
• un transistor T1 dont un drain est connecté à un pied du pont diviseur et dont une source est connectée à une masse du circuit, un signal de sélection (E1) étant appliqué sur une grille de commande du transistor T1,
• un transistor T2 dont un drain est connecté à une entrée d'inhibition du circuit de production de courant et dont une source est connectée à la masse, le signal de sélection (E1) étant appliqué sur une grille de commande du transistor T2.

5. Circuit selon l'une des revendication précédentes, dans lequel le circuit (50, Q9, T2, T3, T4) de production d'un courant de référence (IREF4) comprend une source (50) pour produire un courant stable (IREF), et des moyens de recopie du dit courant stable pour produire le courant de référence (IREF4).

6. Circuit selon la revendication précédente, dans lequel la source (50) comprend un ensemble de transistors bipolaires (Q1 à Q6) associés à une résistance R3 formant une structure produisant le courant de référence égal à VT/R3, VT étant un paramètre caractéristique d'un transistor bipolaire,
et dans lequel la source comprend également un circuit d'initialisation (D1) pour décharger un condensateur parasite d'un transistor bipolaire (Q5) dans lequel circule le courant stable.

7. Circuit selon la revendication précédente, dans lequel le circuit d'initialisation est une diode (D1) comprenant un premier pôle sur lequel est appliqué le potentiel d'alimentation et un deuxième pôle connecté à un émetteur du dit transistor(Q5) dans lequel circule le courant stable.
